# EUROPEAN PATENT APPLICATION

(11) **EP 4 553 524 A2**
(43) Date of publication of application: **14.05.2025**
(21) Application number: 23912902.6
(22) Date of filing: 26.12.2023
(51) Int. Cl.: G01R 31/396, G01R 31/367, G01R 31/3835, G01R 31/385, G01R 19/165, G01R 19/10, G01R 31/392

(54) **APPARATUS AND METHOD FOR MANAGING BATTERY**

(30) Priority: 26.12.2022 KR 20220185034
(71) Applicant: LG Energy Solution, Ltd., Seoul 07335 (KR)
(72) Inventor: CHOI, Soon-Ju, Daejeon 34122 (KR); KIM, Dae-Soo, Daejeon 34122 (KR); KIM, Young-Deok, Daejeon 34122 (KR)
(74) Representative: Goddar, Heinz J.
(86) International application number: PCT/KR2023/021621
(87) International publication number: WO 2024/144227

(57) **Abstract**

A battery management apparatus according to an embodiment of the present disclosure includes a profile obtaining unit configured to obtain a differential profile based on voltage and capacity of a battery; a control unit configured to generate a comparison differential profile based on a preset reference positive electrode profile and a preset reference negative electrode profile, adjust the reference positive electrode profile and the reference negative electrode profile so that the comparison differential profile corresponds to the differential profile, and determine an adjustment positive electrode profile and an adjustment negative electrode profile according to the adjustment result as a positive electrode profile and a negative electrode profile of the battery, respectively.

## Description

### TECHNICAL FIELD

The present application claims priority to Korean Patent Application No. 10-2022-0185034 filed on December 26, 2022 in the Republic of Korea and Korean Patent Application No. 10-2023-0191446 filed on December 26, 2023 in the Republic of Korea, the disclosures of which are incorporated herein by reference.

The present disclosure relates to a battery management apparatus and method, and more particularly, to a battery management apparatus and method for estimating a positive and negative electrode profile representing a current state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being done on these batteries in terms of increasing capacity and density, but improving lifespan and safety is also important. **In** order to improve battery safety, technology to accurately diagnose the current state of the battery is required.

**In** general, manufactured batteries are not easy to disassemble and assemble, so it is very difficult to accurately measure the positive electrode state and negative electrode state of the battery. Therefore, a technology for estimating the current state of the battery is required by estimating the positive electrode profile representing the positive electrode state of the battery and the negative electrode profile representing the negative electrode state of the battery.

### DISCLOSURE

### Technical Problem

The present disclosure is designed to solve the problems of the related art, and therefore the present disclosure is directed to providing a battery management apparatus and method for more accurately estimating a positive electrode profile and a negative electrode profile of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a profile obtaining unit configured to obtain a differential profile based on voltage and capacity of a battery; a control unit configured to generate a comparison differential profile based on a preset reference positive electrode profile and a preset reference negative electrode profile, adjust the reference positive electrode profile and the reference negative electrode profile so that the comparison differential profile corresponds to the differential profile, and determine an adjustment positive electrode profile and an adjustment negative electrode profile according to the adjustment result as a positive electrode profile and a negative electrode profile of the battery, respectively.

The control unit may be configured to generate a comparison full-cell profile based on the reference positive electrode profile and the reference negative electrode profile, and generate the comparison differential profile based on the generated comparison full-cell profile.

The control unit may be configured to calculate an error between the differential profile and the comparison differential profile and adjust the reference positive electrode profile and the reference negative electrode profile until the calculated error is minimized.

The profile obtaining unit may be configured to obtain at least one of a first differential profile representing the corresponding relationship between capacity and differential voltage of the battery and a second differential profile representing the corresponding relationship between voltage and differential capacity of the battery.

The profile obtaining unit may be configured to obtain the first differential profile and the second differential profile.

The control unit may be configured to generate a first comparison differential profile corresponding to the first differential profile and a second comparison differential profile corresponding to the second differential profile based on the reference positive electrode profile and the reference negative electrode profile.

The control unit may be configured to generate a comparison full-cell profile based on the reference positive electrode profile and the reference negative electrode profile, differentiate the comparison full-cell profile with respect to capacity to generate the first comparison differential profile, and differentiate the comparison full-cell profile with respect to voltage to generate the second comparison differential profile.

The control unit may be configured to adjust the reference positive electrode profile and the reference negative electrode profile based on a first error between the first differential profile and the first comparison differential profile and a second error between the second differential profile and the second comparison differential profile.

The control unit may be configured to adjust the reference positive electrode profile and the reference negative electrode profile until the sum error of the first error and the second error is minimized.

A battery pack according to another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a profile obtaining step of obtaining a differential profile based on voltage and capacity of a battery; a comparison differential profile generating step of generating a comparison differential profile based on a preset reference positive electrode profile and a preset reference negative electrode profile; a profile adjusting step of adjusting the reference positive electrode profile and the reference negative electrode profile so that the comparison differential profile corresponds to the differential profile; and a profile determining step of determining an adjustment positive electrode profile and an adjustment negative electrode profile according to the adjustment result of the profile adjusting step as a positive electrode profile and a negative electrode profile of the battery, respectively.

### Advantageous Effects

According to one aspect of the present disclosure, the battery management apparatus adjusts the reference positive electrode profile and the reference negative electrode profile to minimize the error between the differential profile and the comparison differential profile, and thus has the advantage of more accurately determining the positive electrode profile and the negative electrode profile of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing a first differential profile according to an embodiment of the present disclosure.
FIG. 3 is a diagram schematically showing a second differential profile according to an embodiment of the present disclosure.
FIG. 4 is a diagram schematically showing a reference positive electrode profile and a reference negative electrode profile according to an embodiment of the present disclosure.
FIG. 5 is a diagram schematically showing a battery profile and a comparison full-cell profile according to an embodiment of the present disclosure.
FIG. 6 is a diagram schematically showing a first differential profile and a first comparison differential profile according to an embodiment of the present disclosure.
FIGS. 7 to 9 are diagrams showing an example of a process of adjusting a reference positive electrode profile and a reference negative electrode profile according to an embodiment of the present disclosure.
FIGS. 10 to 12 are diagrams showing another example of the process of adjusting the reference positive electrode profile and the reference negative electrode profile according to an embodiment of the present disclosure.
FIG. 13 is a diagram schematically showing a second differential profile and a second comparison differential profile according to an embodiment of the present disclosure.
FIG. 14 is a diagram schematically showing a battery pack according to another embodiment of the present disclosure.
FIG. 15 is a diagram schematically showing a vehicle according to still another embodiment of the present disclosure.
FIG. 16 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

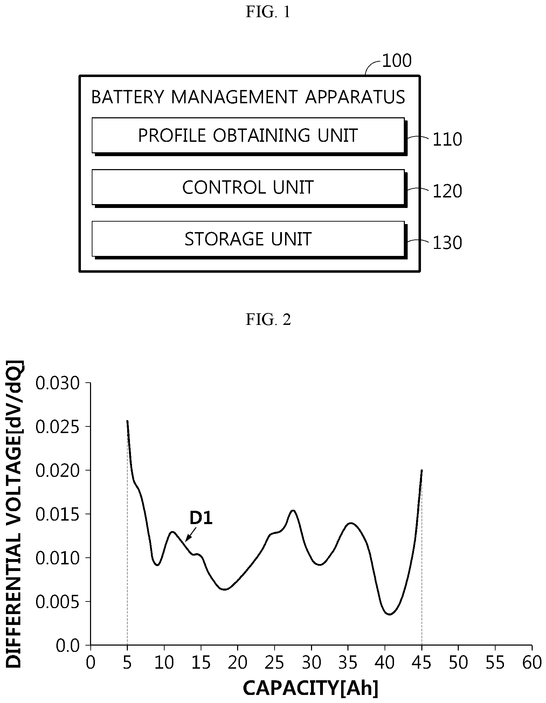

FIG. 1 is a diagram schematically showing a battery management apparatus 100 according to an embodiment of the present disclosure.

Referring to FIG. 1, the battery management apparatus 100 may include a profile obtaining unit 110 and a control unit 120.

Here, the battery means one physically separable independent cell including a negative electrode terminal and a positive electrode terminal. For example, one lithium-ion battery or lithium polymer battery may be regarded as a battery. Additionally, the type of battery may be cylindrical type, prismatic type, or pouch type. Additionally, the battery may mean a battery bank, battery module, or battery pack in which a plurality of cells are connected in series and/or parallel. Hereinafter, for convenience of explanation, the battery is explained as meaning one independent cell.

The profile obtaining unit 110 may be configured to obtain a differential profile based on the voltage and capacity of the battery.

For example, the battery profile is a profile that represents the corresponding relationship between voltage (V) and capacity (Q) when the SOC of the battery is charged from the preset charging start SOC or 0% to the preset charging end SOC or 100%. As another example, the battery profile may represent the corresponding relationship between voltage (V) and capacity (Q) when the SOC of the battery is discharged from the preset charging start SOC or 100% to the preset charging end SOC or 0%.

Also, by differentiating the battery profile with respect to capacity, a capacity-differential voltage profile (hereinafter, first differential profile D1) representing the corresponding relationship between differential voltage (dV/dQ) and capacity (Q) may be generated. Conversely, when the battery profile is differentiated with respect to voltage, a voltage-differential capacity profile (hereinafter, second differential profile D2) representing the corresponding relationship between differential capacity (dQ/dV) and voltage (V) may be generated.

For example, there is no special limitation on the C-rate in charging or discharging to generate the battery profile. However, preferably, in order to obtain the battery profile and the differential profile more accurately, the battery should be charged or discharged at a low rate. For example, in the process of charging or discharging a battery at 0.05 C, the battery profile may be generated.

For example, the profile obtaining unit 110 may directly receive the differential profile of the battery from the outside. That is, the profile obtaining unit 110 may obtain the differential profile by receiving the differential profile by being connected to the outside by wire and/or wirelessly.

As another example, the profile obtaining unit 110 may receive battery information about the voltage and capacity of the battery. Also, the profile obtaining unit 110 may generate the battery profile based on the received battery information and generate the differential profile based on the generated battery profile. That is, the profile obtaining unit 110 may obtain the differential profile by directly generating the differential profile based on the battery information.

The profile obtaining unit 110 may be connected to communicate with the control unit 120. For example, the profile obtaining unit 110 may be connected to the control unit 120 by wire and/or wirelessly. The profile obtaining unit 110 may transmit the obtained differential profile to the control unit 120.

Specifically, the profile obtaining unit 110 may be configured to obtain at least one of a first differential profile D1 representing the corresponding relationship between the capacity and the differential voltage of the battery and a second differential profile D2 representing the corresponding relationship between the voltage and differential capacity of the battery.

FIG. 2 is a diagram schematically showing a first differential profile D1 according to an embodiment of the present disclosure. For example, in the embodiment of FIG. 2, the first differential profile D1 may be expressed as an X-Y graph where the X-axis is capacity (Q) and the Y-axis is differential voltage (dV/dQ).

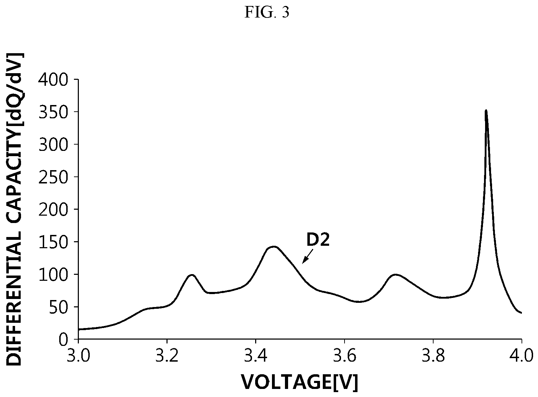

FIG. 3 is a diagram schematically showing a second differential profile D2 according to an embodiment of the present disclosure. For example, in the embodiment of FIG. 3, the second differential profile D2 may be expressed as an X-Y graph in which the X-axis is voltage (V) and the Y-axis is differential capacity (dQ/dV).

The control unit 120 may be configured to generate a comparison differential profile based on a preset reference positive electrode profile and a preset reference negative electrode profile.

First, the control unit 120 may be configured to generate a comparison full-cell profile based on the reference positive electrode profile and the reference negative electrode profile.

Specifically, the reference positive electrode profile may be a profile representing the corresponding relationship between the capacity and voltage of a preset reference positive electrode cell to correspond to the positive electrode of the battery. For example, the reference positive electrode cell may be the positive electrode of a positive electrode coin half-cell or a three-electrode cell. Additionally, the reference negative electrode profile may be a profile representing the corresponding relationship between the capacity and voltage of a preset reference negative electrode cell to correspond to the negative electrode of the battery. For example, the reference negative electrode cell may be the negative electrode of a negative electrode coin half-cell or a three-electrode cell.

The control unit 120 may generate a comparison full-cell profile that represents the voltage difference by capacity between the reference positive electrode profile and the reference negative electrode profile. For example, the control unit 120 may calculate the difference between the positive electrode potential of the reference positive electrode profile and the negative electrode potential of the reference negative electrode profile for each capacity, and generate a comparison full-cell profile according to the calculated result.

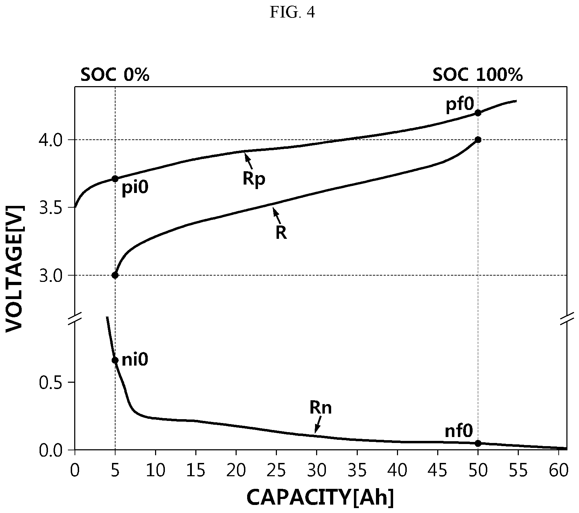

FIG. 4 is a diagram schematically showing a reference positive electrode profile Rp and a reference negative electrode profile Rn according to an embodiment of the present disclosure.

For example, in the embodiment of FIG. 4, the control unit 120 may calculate the voltage difference between the reference positive electrode profile Rp and the reference negative electrode profile Rn in the capacity section from 5 [Ah] to 50 [Ah], and generate a comparison full-cell profile R according to the calculated voltage difference. The capacity section of the comparison full-cell profile R is 5 [Ah] to 50 [Ah], and the voltage section is 3.0 [V] to 4.0 [V].

The control unit 120 may be configured to generate a comparison differential profile based on the generated comparison full-cell profile R.

Specifically, the control unit 120 may generate a comparison differential profile by differentiating the comparison full-cell profile R with respect to voltage or capacity. Preferably, the control unit 120 may generate a comparison differential profile to correspond to the differential profile obtained by the profile obtaining unit 110.

For example, when the profile obtaining unit 110 obtains the first differential profile D1, the control unit 120 may generate a first comparison differential profile DR1 representing the corresponding relationship between capacity (Q) and differential voltage (dV/dQ) by differentiating the comparison full-cell profile R with respect to capacity.

As another example, when the profile obtaining unit 110 obtains the second differential profile D2, the control unit 120 may generate a second comparison differential profile DR2 representing the corresponding relationship between voltage (V) and differential capacity (dQ/dV) by differentiating the comparison full-cell profile R with respect to voltage.

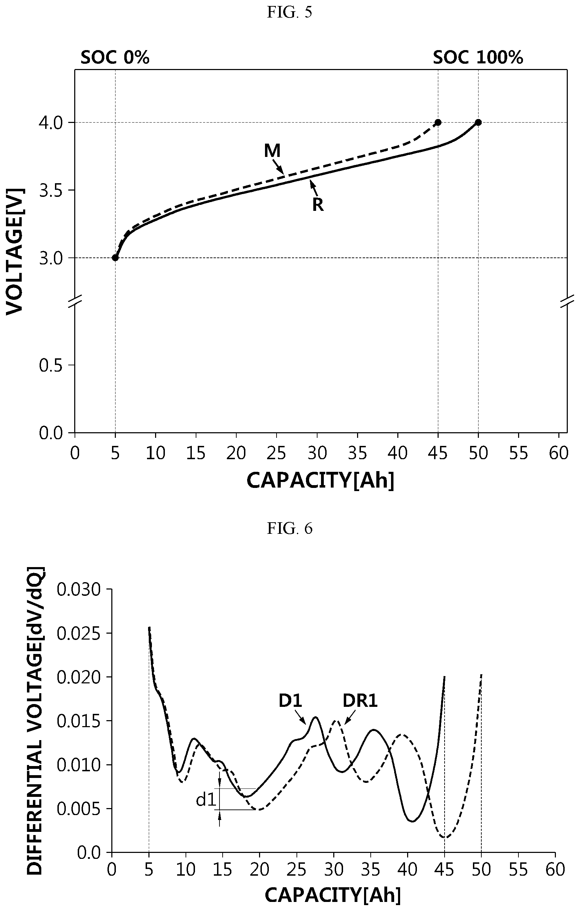

FIG. 5 is a diagram schematically showing a battery profile M and a comparison full-cell profile R according to an embodiment of the present disclosure. FIG. 6 is a diagram schematically showing a first differential profile D1 and a first comparison differential profile DR1 according to an embodiment of the present disclosure.

In the embodiments of FIGS. 5 and 6, the result of the battery profile M being differentiated with respect to capacity is the first differential profile D 1, and the result of the comparison full-cell profile R being differentiated with respect to capacity is the first comparison differential profile DR1.

In the embodiment of FIG. 6, the control unit 120 may generate a first comparison differential profile DR1 by differentiating the comparison full-cell profile R with respect to capacity to correspond to the first differential profile D1.

The control unit 120 may be configured to adjust the reference positive electrode profile Rp and the reference negative electrode profile Rn so that the comparison differential profile corresponds to the differential profile.

Specifically, the control unit 120 may be configured to calculate the error between the differential profile and the comparison differential profile.

For example, in the embodiment of FIG. 6, the control unit 120 may calculate the root mean square error (RMSE) of the first differential profile D1 and the first comparison differential profile DR1. As another example, in the embodiment of FIG. 6, the control unit 120 may calculate the differential voltage difference d1 for each capacity of the first differential profile D1 and the first comparison differential profile DR1. In addition, the control unit 120 may calculate the error of the first differential profile D1 and the first comparison differential profile DR1 by summing the calculated plurality of differential voltage differences d1. Here, the differential voltage difference d1 is a unit error of the first differential profile D1 and the first comparison differential profile DR1 at the corresponding capacity, and the sum of the differential voltage differences d1 is the error of the first differential profile D1 and the first comparison differential profile DR1.

The control unit 120 may be configured to adjust the reference positive electrode profile Rp and the reference negative electrode profile Rn until the calculated error is minimized.

Specifically, the control unit 120 may adjust the reference positive electrode profile Rp and the reference negative electrode profile Rn by shifting or capacity scaling so that the error between the comparison differential profile and the differential profile is minimized.

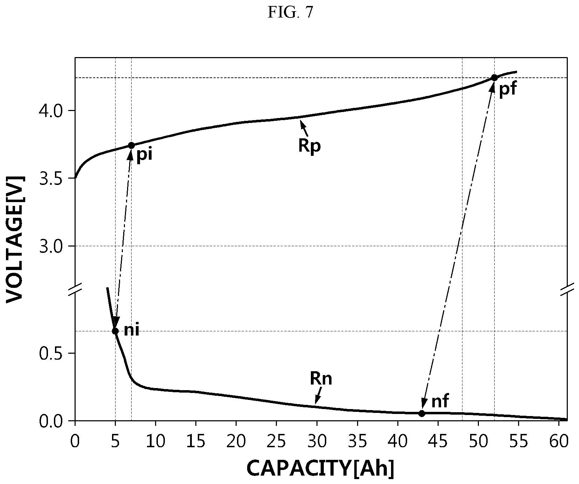

Specific embodiments of adjusting the reference positive electrode profile Rp and the reference negative electrode profile Rn will be described later with reference to FIGS. 7 to 12.

The control unit 120 may be configured to determine the adjustment positive electrode profile and adjustment negative electrode profile according to the adjustment result as the positive electrode profile and the negative electrode profile of the battery, respectively.

Specifically, the control unit 120 may generate a plurality of comparison full-cell profiles R by adjusting the reference positive electrode profile Rp and the reference negative electrode profile Rn. Additionally, the control unit 120 may generate a plurality of comparison differential profiles based on the plurality of comparison full-cell profiles R. The control unit 120 may specify a comparison differential profile that has a minimum error with the differential profile among the plurality of comparison differential profiles. Additionally, the control unit 120 may determine the adjustment positive electrode profile and the adjustment negative electrode profile corresponding to the specified comparison differential profile as the positive electrode profile and the negative electrode profile of the battery, respectively.

The battery management apparatus 100 according to an embodiment of the present disclosure adjusts the reference positive electrode profile Rp and the reference negative electrode profile Rn to minimize the error between the differential profile and the comparison differential profile, and thus has the advantage of being able to more accurately determining the positive electrode profile and the negative electrode profile of the battery.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the differential profiles D1, D2 obtained by the profile obtaining unit 110 may be stored in the storage unit 130. Additionally, the storage unit 130 may store a preset reference positive electrode profile Rp and a preset reference negative electrode profile Rn. Additionally, the control unit 120 may access the storage unit 130 to obtain the stored profile.

Below, an embodiment in which the control unit 120 adjusts the reference positive electrode profile Rp and the reference negative electrode profile Rn will be described in more detail.

FIGS. 7 to 9 are diagrams showing an example of a process of adjusting a reference positive electrode profile Rp and a reference negative electrode profile Rn according to an embodiment of the present disclosure.

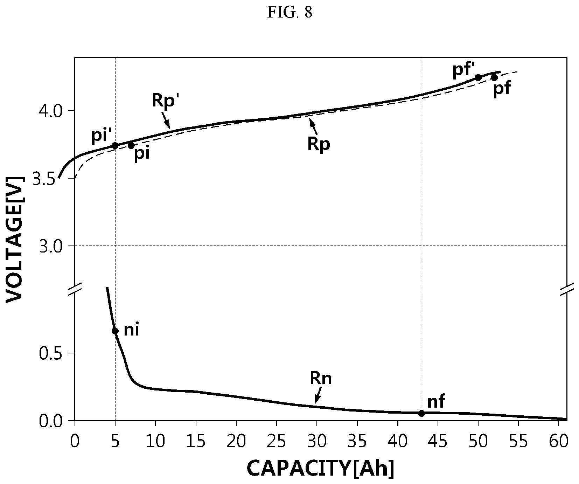

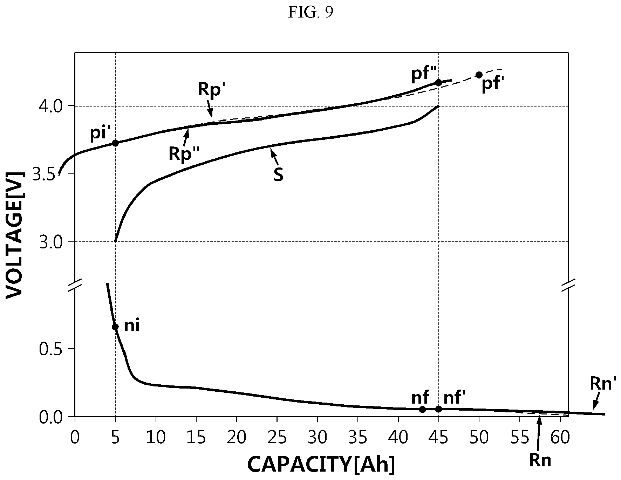

The procedure of generating the comparison full-cell profile S, which will be described with reference to FIGS. 7 to 9, proceeds in the following order: a first routine for setting four points (positive electrode participation start point, positive electrode participation end point, negative electrode participation start point, negative electrode participation end point) to correspond to the voltage range of interest (see FIG. 7), a second routine for performing profile shifting (see FIG. 8), and a third routine for performing capacity scaling (see FIG. 9). That is, the procedure of generating the comparison full-cell profile S according to an embodiment of the present disclosure includes the first to third routines.

First, referring to FIG. 7, the reference positive electrode profile Rp and the reference negative electrode profile Rn are the same as those shown in FIG. 4.

The control unit 120 determines a positive electrode participation start point pi, a positive electrode participation end point pf, a negative electrode participation start point ni, and a negative electrode participation end point nf on the reference positive electrode profile Rp and the reference negative electrode profile Rn.

Either the positive electrode participation start point pi or the negative electrode participation start point ni depends on the other.

As an example, the control unit 120 may divide the positive electrode voltage range from the start point to the end point of the reference positive electrode profile Rp into a plurality of micro voltage sections, and then set the boundary point of two adjacent micro voltage sections among the plurality of micro voltage sections as the positive electrode participation start point pi. Each micro voltage section may have a predetermined size (e.g., 0.01 V). Next, the control unit 120 may set a point on the reference negative electrode profile Rn that is smaller than the positive electrode participation start point pi by the first set voltage (e.g., 3 V) as the negative electrode participation start point ni.

As another example, the control unit 120 may divide the negative electrode voltage range from the start point to the end point of the reference negative electrode profile Rn into a plurality of micro voltage sections of a predetermined size, and then set the boundary point between two adjacent micro voltage sections among the plurality of micro voltage sections as the negative electrode participation start point ni. Next, the control unit 120 may search for a point greater than the negative electrode participation start point ni by the first set voltage from the reference positive electrode profile Rp and set the searched point as the positive electrode participation start point pi.

Either the positive electrode participation end point pf or the negative electrode participation end point nf depends on the other.

As an example, the control unit 120 may divide the voltage range from the second set voltage to the end point of the reference positive electrode profile Rp into a plurality of micro voltage sections of a predetermined size, and then set the boundary point between two adjacent micro voltage sections among the plurality of micro voltage sections as the positive electrode participation end point pf. Next, the control unit 120 may set a point on the reference negative electrode profile Rn that is smaller than the positive electrode participation end point pf by the second set voltage (e.g., 4 V) as the negative electrode participation end point nf.

As another example, the control unit 120 may divide the negative electrode voltage range from the start point to the end point of the reference negative electrode profile Rn into a plurality of micro voltage sections of a predetermined size, and then set the boundary point between two adjacent micro voltage sections among the plurality of micro voltage sections as the negative electrode participation end point nf. Next, the control unit 120 may search for a point greater than the negative electrode participation end point nf by the second set voltage from the reference positive electrode profile Rp and set the searched point as the positive electrode participation end point pf.

When the determination of the positive electrode participation start point pi, the positive electrode participation end point pf, the negative electrode participation start point ni, and the negative electrode participation end point nf is completed, the control unit 120 shifts at least one of the reference positive electrode profile Rp and the reference negative electrode profile Rn to the left or right along the horizontal axis.

Referring to FIG. 8, the control unit 120 may shift the reference positive electrode profile Rp and/or the reference negative electrode profile Rn so that the capacity values of the positive electrode participation start point pi and the negative electrode participation start point ni match.

Alternatively, the control unit 120 may shift the reference positive electrode profile Rp and/or the reference negative electrode profile Rn so that the voltages of the positive electrode participation end point pf and the negative electrode participation end point nf match.

FIG. 8 illustrates the situation where only the reference positive electrode profile Rp is shifted to the left to generate an adjusted reference positive electrode profile Rp', and as a result, the voltage of the positive electrode participation start point pi' matches the voltage of the negative electrode participation start point ni. The adjusted reference positive electrode profile Rp' is the result of applying the adjustment procedure for shifting to the left by the voltage difference between the positive electrode participation start point pi and the negative electrode participation start point ni to the reference positive electrode profile Rp. Therefore, the two points pi, pi' differ only in capacity value and have the same voltage. Two points pf, pf' differ only in capacity value and have the same voltage.

When the adjustment result profiles Rp', Rn obtained by shifting at least one of the reference positive electrode profile Rp and the reference negative electrode profile Rn are secured, the control unit 120 scales the capacity range of at least one of the adjustment result profiles Rp', Rn.

According to the embodiment of FIG. 8, the control unit 120 performs an additional adjustment procedure to shrink or expand at least one of the adjusted reference positive electrode profile Rp' and the reference negative electrode profile Rn along the horizontal axis.

Referring to FIG. 9, the control unit 120 may generate an adjusted reference positive electrode profile Rp" by shrinking or expanding the adjusted reference positive electrode profile Rp' so that the size of the capacity range between the two points pi', pf' of the adjusted reference positive electrode profile Rp' matches the size of the capacity range of the battery profile M. At this time, one of the two points pi', pf' may be fixed. Accordingly, the capacity difference between the two points pi', pf'' of the adjusted reference positive electrode profile Rp" may match the capacity range of the battery profile M.

In addition, the control unit 120 may generate an adjusted reference negative electrode profile Rn' by shrinking or expanding the reference negative electrode profile Rn so that the size of the capacity range between the two points ni, nf of the reference negative electrode profile Rn matches the size of the capacity range of the battery profile M. At this time, one of the two points ni, nf may be fixed. Accordingly, the capacity difference between the two points ni, nf' of the adjusted reference negative electrode profile Rn' may match the capacity range of the battery profile M.

In FIG. 9, the adjusted reference positive electrode profile Rp'' is the result of shrinkage of the adjusted reference positive electrode profile Rp' shown in FIG. 8, and the adjusted reference negative electrode profile Rn' is the result of expansion of the reference negative electrode profile Rn shown in FIG. 8.

The positive electrode participation end point pf" on the adjusted reference positive electrode profile Rp'' corresponds to the positive electrode participation end point pf on the adjusted reference positive electrode profile Rp'. The negative electrode participation end point nf' on the adjusted reference negative electrode profile Rn' corresponds to the negative electrode participation end point nf on the reference negative electrode profile Rn.

The capacity difference between the positive electrode participation start point pi' and the positive electrode participation end point pf'' of the adjusted reference positive electrode profile Rp'' matches the size of the capacity range of the battery profile M. Likewise, the capacity difference between the negative electrode participation start point ni and the negative electrode participation end point nf' of the adjusted reference negative electrode profile Rn' matches the size of the capacity range of the battery profile M.

In addition, the capacity range by the two points pi', pf'' of the adjusted reference positive electrode profile Rp" matches the capacity range by the two points ni, nf' of the adjusted reference negative electrode profile Rn'. The control unit 120 may generate a comparison full-cell profile S by subtracting the profile between two points pi, pf' of the adjusted reference positive electrode profile Rp'' from the profile between two points ni, nf' of the adjusted reference negative electrode profile Rn'.

The control unit 120 may generate a comparison differential profile from the comparison full-cell profile S and calculate the error (profile error) between the comparison differential profile and the differential profile. When the error between the comparison differential profile and the differential profile is minimized, the adjusted reference positive electrode profile Rp" corresponding to the comparison full-cell profile S may be determined as the adjustment positive electrode profile, and the adjusted reference negative electrode profile Rn' may be determined as the adjustment negative electrode profile.

The control unit 120 may map at least two of the adjusted reference positive electrode profile Rp", the adjusted reference negative electrode profile Rn', the positive electrode participation start point pi', the positive electrode participation end point pf'', the negative electrode participation start point ni, the negative electrode participation end point nf', the positive electrode change rate ps, the negative electrode change rate ns, the comparison full-cell profile S and the profile error with each other and record in the storage unit 130. Here, the control unit 120 may calculate the change rate of the adjusted reference positive electrode profile Rp'' for the reference positive electrode profile Rp as the positive electrode change rate ps. Additionally, the control unit 120 may calculate the change rate of the adjusted reference positive electrode profile Rn' for the reference negative electrode profile Rn as the negative electrode change rate ns.

Meanwhile, as described above, when the positive electrode voltage range of the reference positive electrode profile Rp is divided into a plurality of micro voltage sections, the boundary point of two adjacent micro voltage sections among the plurality of micro voltage sections may be set as the positive electrode participation start point pi.

For example, if the positive electrode voltage range of the reference positive electrode profile Rp is divided into 100 micro voltage ranges, there may be 100 boundary points that can be set as the positive electrode participation start point pi. Additionally, if the voltage range greater than or equal to the second set voltage in the reference positive electrode profile Rp is divided into 40 micro voltage ranges, there may be 40 boundary points that can be set as the positive electrode participation end point pf. In this case, up to 4000 different comparison full-cell profiles may be generated.

Of course, it will be easily understood that, as the size of the micro voltage section decreases, the number of comparison full-cell profiles that can be maximally generated increases, and conversely, as the size of the micro voltage section increases, the number of comparison full-cell profiles that can be maximally generated decreases.

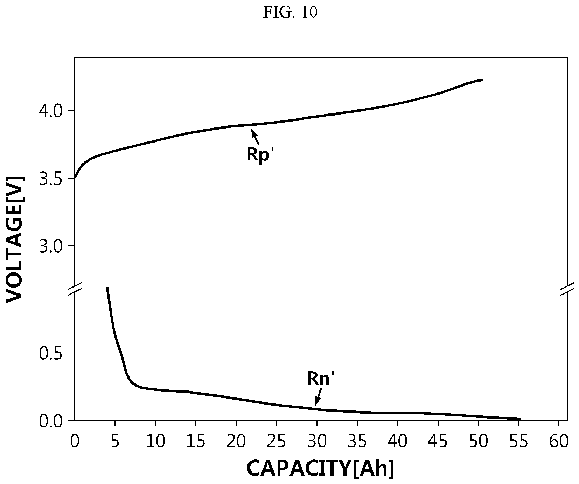

FIGS. 10 to 12 are diagrams showing another example of the process of adjusting the reference positive electrode profile Rp and the reference negative electrode profile Rn according to an embodiment of the present disclosure. Specifically, FIGS. 10 to 12 are diagrams referenced for explaining another example of a procedure for generating the comparison full-cell profile U. For reference, the embodiment shown in FIGS. 10 to 12 is independent from the embodiment shown in FIGS. 7 to 9. Accordingly, terms or symbols commonly used to describe the embodiment shown in FIGS. 7 to 9 and the embodiment shown in FIGS. 10 to 12 should be understood as being limited to each embodiment.

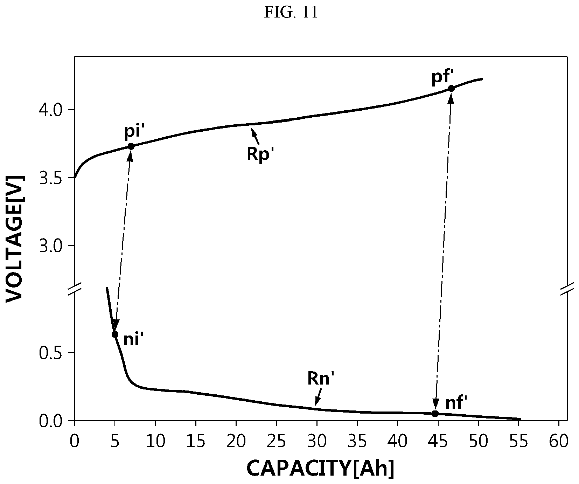

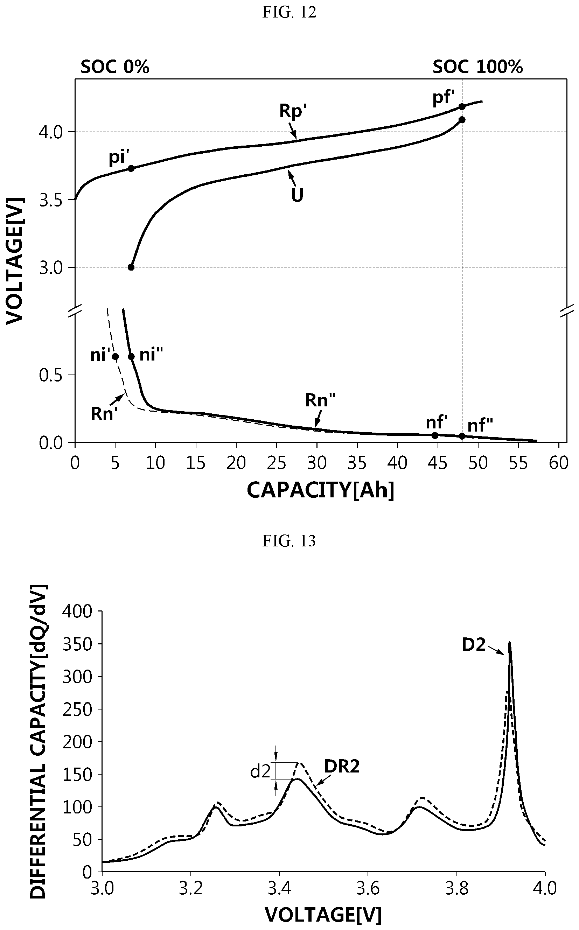

The procedure of generating the comparison full-cell profile U, which will be explained with reference to FIGS. 10 to 12, proceeds in the following order: a fourth routine for performing capacity scaling (see FIG. 10), a fifth routine for setting four points (positive electrode participation start point, positive electrode participation end point, negative electrode participation start point, negative electrode participation end point) (see FIG. 11), and a sixth routine for performing profile shift (see FIG. 12). That is, the procedure of generating the comparison full-cell profile U according to another embodiment of the present disclosure includes the fourth to sixth routines.

Referring to FIG. 10, the reference positive electrode profile Rp and the reference negative electrode profile Rn are the same as those shown in FIG. 6.

The control unit 120 generates an adjusted reference positive electrode profile Rp' and an adjusted reference negative electrode profile Rn' by applying the first scale factor and the second scale factor selected from the scaling number range to the reference positive electrode profile Rp and the reference negative electrode profile Rn, respectively.

The scaling number range may be predetermined or may vary depending on the ratio of the size of the capacity range of the battery profile M to the size of the capacity range of the reference full-cell profile R. As an example, if it is possible to select the first scale factor and the second scale factor among values spaced at 0.1% intervals (i.e., 90%, 90.1%, 90.2%, ..., 98.9%, 99%) of the scaling number range (e.g., 90 to 99%), 91 values can be selected as the first scale factor and the second scale factor, respectively. In this case, up to 8,281 adjusted profile pairs may be generated according to 91 × 91 = 8,281 adjustment levels (combination of first scale factor and second scale factor). The adjusted profile pair refers to a combination of an adjusted reference positive electrode profile and an adjusted reference negative electrode profile.

FIG. 10 shows an example in which the adjusted reference positive electrode profile Rp' and the adjusted reference negative electrode profile Rn' are the results of applying the first scale factor and the second scale factor of less than 100% to the reference positive electrode profile Rp and the reference negative electrode profile Rn, respectively.

Since the first scale factor and the second scale factor are less than 100%, the adjusted reference positive electrode profile Rp' is the contraction of the reference positive electrode profile Rp along the horizontal axis, and the adjusted reference negative electrode profile Rn' is also the contraction of the reference negative electrode profile Rn along the horizontal axis. To facilitate understanding, it is illustrated that the start point of each of the positive electrode profile Rp and the reference negative electrode profile Rn is fixed and the remaining portions are reduced to the left along the horizontal axis.

Referring to FIG. 11, the control unit 120 determines the positive electrode participation start point pi', the positive electrode participation end point pf', the negative electrode participation start point ni', and the negative electrode participation end point nf' on the adjusted reference positive electrode profile Rp' and the adjusted reference negative electrode profile Rn'.

Either the positive electrode participation start point pi' or the negative electrode participation start point ni' may depend on the other. Additionally, either the positive electrode participation end point pf' or the negative electrode participation end point nf' may depend on the other. Additionally, either the positive electrode participation start point pi' or the positive electrode participation end point pf' may be set based on the other.

That is, when any one of the positive electrode participation start point pi', the positive electrode participation end point pf', the negative electrode participation start point ni', and the negative electrode participation end point nf' is set, the remaining three points may be set automatically by the first set voltage, the second set voltage and/or the size of the capacity range of the battery profile M (e.g., charging capacity of SOC 0 to 100%).

As an example, the control unit 120 may divide the positive electrode voltage range from the start point to the end point (or second set voltage) of the adjusted reference positive electrode profile Rp' into a plurality of micro voltage sections, and then set the boundary point of two adjacent micro voltage sections among the plurality of micro voltage sections as the positive electrode participation start point pi'. Next, the control unit 120 may set a point on the adjusted reference negative electrode profile Rn' that is smaller than the positive electrode participation start point pi' by the first set voltage (e.g., 3 V) as the negative electrode participation start point ni'.

As another example, the control unit 120 may divide the negative electrode voltage range from the start point to the end point of the adjusted reference negative electrode profile Rn' into a plurality of micro voltage sections of a predetermined size, and then set the boundary point of two adjacent micro voltage sections among the plurality of micro voltage sections as the negative electrode participation start point ni'. Next, the control unit 120 may search for a point greater than the negative electrode participation start point ni' by the first set voltage in the adjusted reference positive electrode profile Rp' and set the searched point as the positive electrode participation start point pi'.

As still another example, the control unit 120 may divide the voltage range from the second set voltage to the end point of the adjusted reference positive electrode profile Rp' into a plurality of micro voltage sections of a predetermined size, and then set the boundary point of two adjacent micro voltage sections among the plurality of micro voltage sections as the positive electrode participation end point pf'. Next, the control unit 120 may search for a point smaller than the positive electrode participation end point pf' by the second set voltage (e.g., 4 V) in the adjusted reference negative electrode profile Rn', and set the searched point as the negative electrode participation end point nf'.

As still another example, the control unit 120 may divide the negative electrode voltage range from the start point to the end point of the adjusted reference negative electrode profile Rn' into a plurality of micro voltage sections of a predetermined size, and then set the boundary point of two adjacent micro voltage sections among the plurality of micro voltage sections as the negative electrode participation end point nf'. Next, the control unit 120 may search for a point greater than the negative electrode participation end point nf' by the second set voltage from the adjusted reference positive electrode profile Rp' and set the searched point as the positive electrode participation end point pf'.

If any one of the positive electrode participation start point pi', the positive electrode participation end point pf', the negative electrode participation start point ni', and the negative electrode participation end point nf' is determined, the control unit 120 may additionally determine the remaining 3 points based on the determined point.

As an example, when the positive electrode participation start point pi' is determined first, the control unit 120 may set a point on the adjusted reference positive electrode profile Rp' with a capacity value greater than the capacity value of the positive electrode participation start point pi' by the size of the capacity range of the battery profile M as the positive electrode participation end point pf'. Additionally, the control unit 120 may search for a point lower than the positive electrode participation start point pi' by the first set voltage from the adjusted reference negative electrode profile Rn' and set the searched point as the negative electrode participation start point ni'. Additionally, the control unit 120 may set a point on the adjusted reference negative electrode profile Rn' with a capacity value greater than the capacity value of the negative electrode participation start point ni' by the size of the capacity range of the battery profile M as the negative electrode participation end point nf'.

As another example, when the positive electrode participation end point pf' is determined first, the control unit 120 may set a point on the adjusted reference positive electrode profile Rp' with a capacity value smaller than the capacity value of the positive electrode participation end point pf' by the size of the capacity range of the battery profile M as the positive electrode participation start point pi'. Additionally, the control unit 120 may search for a point lower than the positive electrode participation end point pf' by the second set voltage from the adjusted reference negative electrode profile Rn' and set the searched point as the negative electrode participation end point nf'. In addition, the control unit 120 may set a point on the adjusted reference negative electrode profile Rn', which has a capacity value smaller than the capacity value of the negative electrode participation end point nf' by the size of the capacity range of the battery profile M, as the negative electrode participation start point ni'.

As still another example, when the negative electrode participation start point ni' is determined, the control unit 120 may set a point on the adjusted reference negative electrode profile Rn' with a capacity value greater than the capacity value of the negative electrode participation start point ni' by the size of the capacity range of the battery profile M as the negative electrode participation end point nf'. Additionally, the control unit 120 may search for a point higher than the negative electrode participation start point ni' by the first set voltage from the adjusted reference positive electrode profile Rp' and set the searched point as the positive electrode participation start point pi'. In addition, the control unit 120 may set a point on the adjusted reference positive electrode profile Rp' having a capacity value greater than the capacity value of the positive electrode participation start point pi' by the size of the capacity range of the battery profile M as the positive electrode participation end point pf'.

As still another example, when the negative electrode participation end point nf' is determined, the control unit 120 may set a point on the adjusted reference negative electrode profile Rn' with a capacity value smaller than the capacity value of the negative electrode participation end point nf' by the size of the capacity range of the battery profile M as the negative electrode participation start point ni'. Additionally, the control unit 120 may search for a point higher than the negative electrode participation end point nf' by the second set voltage from the adjusted reference positive electrode profile Rp' and set the searched point as the positive electrode participation end point pf'. In addition, the control unit 120 may set a point on the adjusted reference positive electrode profile Rp' having a capacity value smaller than the capacity value of the positive electrode participation end point pf' by the size of the capacity range of the battery profile M as the positive electrode participation start point pi'.

Once the determination of the positive electrode participation start point pi', the positive electrode participation end point pf', the negative electrode participation start point ni', and the negative electrode participation end point nf' is completed based on the pair of first scale factor and second scale factor, the control Unit 120 may shift at least one of the adjusted reference positive electrode profile Rp' and the adjusted reference negative electrode profile Rn' along the horizontal axis so that the capacity values of the positive electrode participation start point pi' and the negative electrode participation start point ni' match, or the capacity values of the positive electrode participation end point pf' and the negative electrode participation end point nf' match.

The adjusted reference negative electrode profile Rn" shown in FIG. 12 is obtained by shifting only the adjusted reference negative electrode profile Rn' shown in FIG. 11 to the right. Accordingly, the capacity values of the positive electrode participation start point pi' and the negative electrode participation start point ni'' match each other. Relatedly, since the capacity difference between the positive electrode participation start point pi' and the positive electrode participation end point pf' is the same as the capacity difference between the negative electrode participation start point ni' and the negative electrode participation end point nf', if the capacity values of the positive electrode participation start point pi' and the negative electrode participation start point ni" match each other, the capacity values of the positive electrode participation end point pf' and the negative electrode participation end point nf'' also match each other.

Referring to FIG. 12, the control unit 120 may generate a comparison full-cell profile U by subtracting the partial profile between two points pi', pf' of the adjusted reference positive electrode profile Rp' from the partial profile between two points ni'', nf'' of the adjusted reference negative electrode profile Rn".

The control unit 120 may generate a comparison differential profile from the comparison full-cell profile U and calculate the error (profile error) between the comparison differential profile and the differential profile. When the error between the comparison differential profile and the differential profile is minimized, the adjusted reference positive electrode profile Rp' corresponding to the comparison full-cell profile U may be determined as the adjustment positive electrode profile, and the adjusted reference negative electrode profile Rn" may be determined by the adjustment negative electrode profile.

The control unit 120 may map at least two of the adjusted reference positive electrode profile Rp', the adjusted reference negative electrode profile Rn", the positive electrode participation start point pi', the positive electrode participation end point pf', the negative electrode participation start point ni", the negative electrode participation end point nf'', the positive electrode change rate ps, the negative electrode change rate ns, the comparison full-cell profile U and the profile error with each other and record in the storage unit 130. For example, the control unit 120 may determine the first scale factor as the positive electrode change rate ps and the second scale factor as the negative electrode change rate ns.

Below, an embodiment in which the control unit 120 determines the positive electrode profile and the negative electrode profile of the battery by considering both the first differential profile D1 and the second differential profile D2 will be described.

The profile obtaining unit 110 may be configured to obtain a first differential profile D1 and a second differential profile D2.

For example, in the embodiment of FIGS. 2 and 3, the profile obtaining unit 110 may obtain both the first differential profile D1 and the second differential profile D2.

The control unit 120 may be configured to generate a first comparison differential profile DR1 corresponding to the first differential profile D1 and a second comparison differential profile DR2 corresponding to the second differential profile D2 based on the reference positive electrode profile Rp and the reference negative electrode profile Rn.

Specifically, the control unit 120 may generate a comparison full-cell profile R based on the reference positive electrode profile Rp and the reference negative electrode profile Rn. Additionally, the control unit 120 may generate a first comparison differential profile DR1 by differentiating the comparison full-cell profile R with respect to capacity. Additionally, the control unit 120 may generate a second comparison differential profile DR2 by differentiating the comparison full-cell profile R with respect to voltage.

The control unit 120 may be configured to adjust the reference positive electrode profile Rp and the reference negative electrode profile Rn based on the first error between the first differential profile D1 and the first comparison differential profile DR1 and the second error between the second differential profile D2 and the second comparison differential profile DR2.

For example, in the embodiment of FIG. 6, the control unit 120 may calculate the root mean square error of the first differential profile D1 and the first comparison differential profile DR1.

FIG. 13 is a diagram schematically showing a second differential profile D2 and a second comparison differential profile DR2 according to an embodiment of the present disclosure.

In the embodiments of FIGS. 5 and 13, the result of the battery profile being differentiated with respect to voltage is the second differential profile D2, and the result of the comparison full-cell profile R being differentiated with respect to capacity is the second comparison differential profile DR2.

For example, in the embodiment of FIG. 13, the control unit 120 may calculate the root mean square error (RMSE) of the second differential profile D2 and the second comparison differential profile DR2. As another example, in the embodiment of FIG. 13, the control unit 120 may calculate the differential capacity difference d2 for each voltage of the second differential profile D2 and the second comparison differential profile DR2. In addition, the control unit 120 may calculate the second error of the second differential profile D2 and the second comparison differential profile DR2 by summing the calculated plurality of differential capacity differences d2. Here, the differential capacity difference d2 is a unit error of the second differential profile D2 and the second comparison differential profile DR2 at the corresponding voltage, and the sum of the differential capacity differences d2 is the error of the second differential profile D2 and the second comparison differential profile DR2.

The control unit 120 may be configured to adjust the reference positive electrode profile Rp and the reference negative electrode profile Rn until the sum error of the first error and the second error is minimized.

Specifically, the control unit 120 may generate a plurality of comparison full-cell profiles R by adjusting the reference positive electrode profile Rp and the reference negative electrode profile Rn. In addition, the control unit 120 may specify a comparison full-cell profile R in which the sum error of the first error between the first differential profile D1 and the first comparison differential profile DR1 and the second error between the second differential profile D2 and the second comparison differential profile DR2 is minimized among the plurality of comparison full-cell profiles R. Additionally, the control unit 120 may determine the adjustment positive electrode profile and the adjustment negative electrode profile corresponding to the specified comparison full-cell profile R as the positive electrode profile and the negative electrode profile of the battery, respectively.

The battery management apparatus 100 according to an embodiment of the present disclosure may determine the positive electrode profile and the negative electrode profile of the battery according to the sum error between the first and second differential profiles D1, D2 and the first and second comparison differential profiles DR1, DR2. Accordingly, the positive electrode profile and the negative electrode profile corresponding to the current state of the battery may be determined more accurately.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the profile obtaining unit 110, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

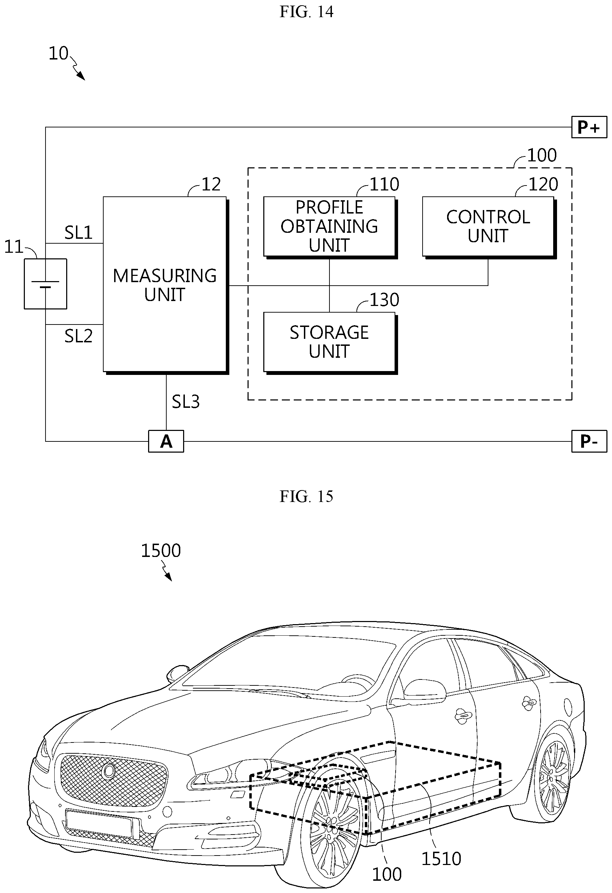

FIG. 14 is a diagram showing a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 may be connected to an ampere meter A through the third sensing line SL3. For example, the ampere meter A may be an ammeter or a shunt resistor capable of measuring the charging current and the discharging current of the battery 11. The measuring unit 12 may calculate the charge amount by measuring the charging current of the battery 11 through the third sensing line SL3. Also, the measuring unit 12 may calculate the discharge amount by measuring the discharge current of the battery 11 through the third sensing line SL3.

An external device may be connected to the positive electrode terminal P+ and the negative electrode terminal P- of the battery pack 10. For example, the external device may be a charging device or a load. Additionally, the positive electrode terminal of the battery 11, the positive electrode terminal P+ of the battery pack 10, an external device, the negative electrode terminal P- of the battery pack 10, and the negative electrode terminal of the battery 11 may be electrically connected.

FIG. 15 is a diagram schematically showing a vehicle 1500 according to still another embodiment of the present disclosure.

Referring to FIG. 15, the battery pack according to an embodiment of the present disclosure may be included in a vehicle 1500 such as an electric vehicle (EV) or a hybrid vehicle (HV). Additionally, the battery pack 1510 may drive the vehicle 1500 by supplying power to the motor through an inverter provided in the vehicle 1500. Here, the battery pack 1510 may include the battery management apparatus 100. That is, the vehicle 1500 may include the battery management apparatus 100. In this case, the battery management apparatus 100 may be an on-board device included in the vehicle 1500.

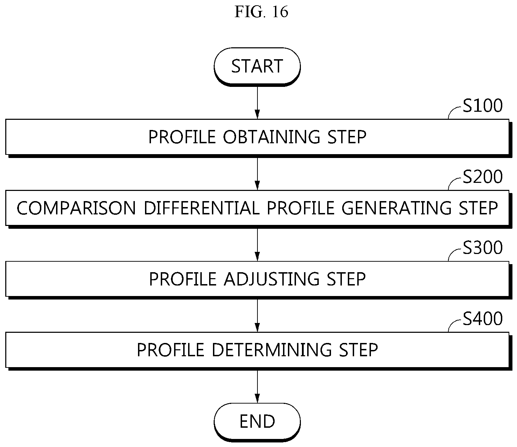

FIG. 16 is a diagram schematically showing a battery management method according to still another embodiment of the present disclosure.

Referring to FIG. 16, the battery management method may include a profile obtaining step (S100), a comparison differential profile generating step (S200), a profile adjusting step (S300), and a profile determining step (S400).

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a differential profile based on voltage and capacity of a battery, and may be performed by the profile obtaining unit 110.

Specifically, the profile obtaining unit 110 may be configured to obtain at least one of a first differential profile D1 representing the corresponding relationship between voltage and differential capacity of the battery and a second differential profile D2 representing the corresponding relationship between capacity and differential voltage of the battery.

The comparison differential profile generating step (S200) is a step of generating comparison differential profiles RD1, RD2 based on a preset reference positive electrode profile Rp and a preset reference negative electrode profile Rn, and may be performed by the control unit 120.

Specifically, the control unit 120 may generate the comparison differential profiles RD1, RD2 by differentiating the comparison full-cell profile R with respect to voltage or capacity. Preferably, the control unit 120 may generate the comparison differential profiles RD1, RD2 to correspond to the differential profiles D1, D2 obtained by the profile obtaining unit 110.

The profile adjusting step (S300) is a step of adjusting the reference positive electrode profile Rp and the reference negative electrode profile Rn so that the comparison differential profiles RD1, RD2 correspond to the differential profiles D1, D2, and may be performed by the control unit 120.

Specifically, the control unit 120 may be configured to calculate the error between the differential profiles D1, D2 and the comparison differential profiles RD1, RD2. Additionally, the control unit 120 may be configured to adjust the reference positive electrode profile Rp and the reference negative electrode profile Rn until the calculated error is minimized.

The profile determining step (S400) is a step of determining the adjustment positive electrode profile and the adjustment negative electrode profile according to the adjustment result of the profile adjusting step (S300) as a positive electrode profile and a negative electrode profile of the battery, respectively, and may be performed by the control unit 120.

Specifically, the control unit 120 may generate a plurality of comparison full-cell profiles by adjusting the reference positive electrode profile and the reference negative electrode profile. Additionally, the control unit 120 may generate a plurality of comparison differential profiles based on the plurality of comparison full-cell profiles. The control unit 120 may specify a comparison differential profile that has a minimum error with the differential profile among the plurality of comparison differential profiles. Additionally, the control unit 120 may determine the adjustment positive electrode profile and the adjustment negative electrode profile corresponding to the specified comparison differential profile as the positive electrode profile and the negative electrode profile of the battery, respectively.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

- 10:: battery pack
- 11:: battery
- 12:: measuring unit
- 100:: battery management apparatus
- 110:: profile obtaining unit
- 120:: control unit
- 130:: storage unit
- 1500:: vehicle
- 1510:: battery pack

## Claims

1. A battery management apparatus, comprising:
a profile obtaining unit configured to obtain a differential profile based on voltage and capacity of a battery;
a control unit configured to generate a comparison differential profile based on a preset reference positive electrode profile and a preset reference negative electrode profile, adjust the reference positive electrode profile and the reference negative electrode profile so that the comparison differential profile corresponds to the differential profile, and determine an adjustment positive electrode profile and an adjustment negative electrode profile according to the adjustment result as a positive electrode profile and a negative electrode profile of the battery, respectively.

2. The battery management apparatus according to claim 1,
wherein the control unit is configured to generate a comparison full-cell profile based on the reference positive electrode profile and the reference negative electrode profile, and generate the comparison differential profile based on the generated comparison full-cell profile.

3. The battery management apparatus according to claim 1,
wherein the control unit is configured to calculate an error between the differential profile and the comparison differential profile and adjust the reference positive electrode profile and the reference negative electrode profile until the calculated error is minimized.

4. The battery management apparatus according to claim 1,
wherein the profile obtaining unit is configured to obtain at least one of a first differential profile representing the corresponding relationship between capacity and differential voltage of the battery and a second differential profile representing the corresponding relationship between voltage and differential capacity of the battery.

5. The battery management apparatus according to claim 4,
wherein the profile obtaining unit is configured to obtain the first differential profile and the second differential profile, and
wherein the control unit is configured to generate a first comparison differential profile corresponding to the first differential profile and a second comparison differential profile corresponding to the second differential profile based on the reference positive electrode profile and the reference negative electrode profile.

6. The battery management apparatus according to claim 5,
wherein the control unit is configured to generate a comparison full-cell profile based on the reference positive electrode profile and the reference negative electrode profile, differentiate the comparison full-cell profile with respect to capacity to generate the first comparison differential profile, and differentiate the comparison full-cell profile with respect to voltage to generate the second comparison differential profile.

7. The battery management apparatus according to claim 5,
wherein the control unit is configured to adjust the reference positive electrode profile and the reference negative electrode profile based on a first error between the first differential profile and the first comparison differential profile and a second error between the second differential profile and the second comparison differential profile.

8. The battery management apparatus according to claim 7,
wherein the control unit is configured to adjust the reference positive electrode profile and the reference negative electrode profile until the sum error of the first error and the second error is minimized.

9. A battery pack, comprising the battery management apparatus according to any one of claims 1 to 8.

10. A vehicle, comprising the battery management apparatus according to any one of claims 1 to 8.

11. A battery management method, comprising:
a profile obtaining step of obtaining a differential profile based on voltage and capacity of a battery;
a comparison differential profile generating step of generating a comparison differential profile based on a preset reference positive electrode profile and a preset reference negative electrode profile;
a profile adjusting step of adjusting the reference positive electrode profile and the reference negative electrode profile so that the comparison differential profile corresponds to the differential profile; and
a profile determining step of determining an adjustment positive electrode profile and an adjustment negative electrode profile according to the adjustment result of the profile adjusting step as a positive electrode profile and a negative electrode profile of the battery, respectively.
